# EUROPEAN PATENT APPLICATION

(11) **EP 4 369 363 A2**
(43) Date of publication of application: **15.05.2024**
(21) Application number: 23209405.2
(22) Date of filing: 13.11.2023
(51) Int. Cl.: H01F 27/28, H01F 27/40, H01F 27/34, H02M 3/158, H02M 3/335

(54) **PLANAR TRANSFORMER**

(30) Priority: 14.11.2022 US 202263425014 P
(71) Applicant: Delta Electronics Inc., Taoyuan City 320023 (TW)
(72) Inventor: CHANG, Yi-Sheng, 320023 Taoyuan City (TW)
(74) Representative: 2K Patentanwälte Blasberg Kewitz & Reichel

(57) **Abstract**

A planar transformer (2B) is applied to an isolated converter (400), and the isolated converter (400) includes a primary-side circuit (1B) and a secondary-side circuit (3B). The planar transformer (2B) includes a circuit board (CB2) and an iron core (C2), and the circuit board (CB2) includes a primary-side layer (LP) and a secondary-side layer (LS). The circuit board (CB2) is arranged in the isolated converter (400), and the primary-side layer (LP) and the secondary-side layer (LS) include a primary-side trace (Tp2) and a secondary-side trace (Ts2) respectively. The primary-side trace (Tp2) is formed on the primary-side layer (LP) and serves as a primary-side coil (22B) coupled to the primary-side circuit (1B). The secondary-side trace (Ts2) is formed on the secondary-side layer (LS) and serves as a secondary-side coil (24B) coupled to the secondary-side circuit (3B). The iron core (C2) includes a core pillar (C22), the core pillar (C22) penetrates a through hole (H4) of the circuit board (CB2), and the primary-side trace (Tp2) and the secondary-side trace (Ts2) surround the through hole (H4).

## Description

### BACKGROUND

### Technical Field

The present disclosure relates to a planar transformer, and more particularly to a planar transformer applied to an isolated converter.

### Description of Related Art

The statements in this section merely provide background information related to the present disclosure and do not necessarily constitute prior art.

With the rapid development of the information industry, power supplies have played an indispensable role. The input voltage of information and household appliances is divided into AC voltage and DC voltage, and power supplies can generally be divided into two levels. In general, the front stage is usually an AC-to-DC converter, a power factor corrector or a DC-to-DC converter, and the rear stage is usually a resonant converter. The power supply usually also includes an auxiliary circuit, and the auxiliary circuit generally converts the power provided by the front-end circuit to provide standby power, auxiliary power, and other power supplies inside the power supply that are not mainly for back-end loads.

In particular, the auxiliary circuit can usually be an isolation converter such as a flyback converter with an isolation transformer to connect the primary side and the secondary side. However, current isolation converters usually use traditional transformers as isolated transformers, which require coils to be wound on a winding frame and an iron core to surround the winding frame to form the structure of the transformer. Since the operating frequency of traditional transformers is too low (such as but not limited to tens of kHz), it requires a larger volume. As a result, the power density of the auxiliary circuit is low, and the excessive size often makes the design difficult, which is not conducive to increase the power density and miniaturize the circuit design.

Therefore, how to design a planar transformer to replace the traditional transformer in the isolated converter to greatly reduce the size of the isolated converter has become a critical topic in this field.

### SUMMARY

In order to solve the above-mentioned problems, the present disclosure provides a planar transformer. The planar transformer is applied to an isolated converter, and the isolated converter includes a primary-side circuit and a secondary-side circuit. The planar transformer includes a circuit board and an iron core. The circuit board is arranged in the isolated converter, and the circuit board includes a primary-side trace and a secondary-side trace. The primary-side trace is formed on a primary-side layer of the circuit board, and the primary-side trace serves as a primary-side coil coupled to the primary-side circuit. The secondary-side trace is formed on a secondary-side layer of the circuit board, and the secondary-side trace serves as a secondary-side coil coupled to the secondary-side circuit. The iron core includes a core pillar, and the core pillar penetrates a through hole of the circuit board, and the primary-side trace and the secondary-side trace surround the through hole. The secondary-side trace has a first width and the primary-side trace has a second width, and the first width is greater than the second width.

In order to solve the above-mentioned problems, the present disclosure provides a planar transformer. The planar transformer is applied to an isolated converter, and the isolated converter includes a primary-side circuit and a secondary-side circuit. The planar transformer includes a circuit board and an iron core. The circuit board is arranged in the isolated converter, and the circuit board includes a primary-side trace and a secondary-side trace. The primary-side trace is formed on a primary-side layer of the circuit board, and the primary-side trace serves as a primary-side coil coupled to the primary-side circuit. The secondary-side trace is formed on a secondary-side layer of the circuit board, and the secondary-side trace serves as a secondary-side coil coupled to the secondary-side circuit. The iron core includes a core pillar, and the core pillar penetrates a through hole of the circuit board, and the primary-side trace and the secondary-side trace surround the through hole. The iron core includes an air gap having a first distance; the primary-side trace, the secondary-side trace, and the through hole have a plurality of second distances, and the second distances are respectively greater than or equal to three times of the first distance.

The main purpose and effect of the present disclosure is to replace the traditional isolation transformer in the isolation converter with the planar transformer so that the primary-side coil and the secondary-side coil are formed on the circuit board in the form of traces. Therefore, the planar transformer can be planarized to significantly increase the space utilization of the isolated converter achieve high power density requirements. In addition, the isolated converter also has a small size due to the use of a planar transformer, which can significantly increase the operating frequency of the isolated converter so that the isolated converter has the advantages of higher efficiency, significantly reduced power switch size, lighter weight, and increased heat dissipation performance.

It is to be understood that both the foregoing general description and the following detailed description are exemplary, and are intended to provide further explanation of the present disclosure as claimed. Other advantages and features of the present disclosure will be apparent from the following description, drawings, and claims.

### BRIEF DESCRIPTION OF DRAWINGS

The present disclosure can be more fully understood by reading the following detailed description of the embodiment, with reference made to the accompanying drawing as follows:
FIG. 1 is a circuit block diagram of an isolated converter of the present disclosure.
FIG. 2A is an exploded view of the three-dimensional circuit structure of a circuit board of the present disclosure.
FIG. 2B is an assembly view of the three-dimensional circuit structure of the circuit board of the present disclosure.
FIG. 3A is a circuit diagram of a transformer coil of the present disclosure.
FIG. 3B is a schematic diagram of the transformer trace configuration of the present disclosure.
FIG. 4 is a schematic diagram of the trace configuration of the primary-side adjacent layer of the present disclosure.

### DETAILED DESCRIPTION

Reference will now be made to the drawing figures to describe the present disclosure in detail. It will be understood that the drawing figures and exemplified embodiments of present disclosure are not limited to the details thereof.

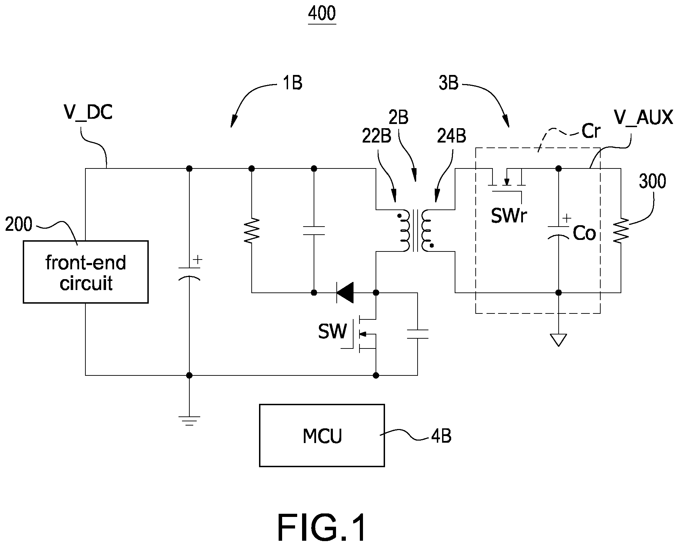

Please refer to FIG. 1, which shows a circuit block diagram of an isolated converter of the present disclosure. The isolated converter 400 may be coupled to the front-end circuit 200 and a load 300, and the front-end circuit 200 may be a DC power supply such as an AC-to-DC converter, a power factor corrector, a DC power source, or so on. The isolated converter 400 includes a primary-side circuit 1B, a transformer 2B, a secondary-side circuit 3B, and a controller 4B, and the transformer 2B includes a primary-side coil 22B and a secondary-side coil 24B. In one embodiment, for example, but not limited to, the isolated converter 400 may be composed of the flyback converter shown in FIG. 1. Therefore, any conversion circuit with the transformer 2B to isolate the primary side and the secondary side should be included in the scope of this embodiment.

The primary-side circuit 1B includes a switch SW, and the secondary-side circuit 3B includes a secondary-side rectification circuit Cr. The secondary-side rectification circuit Cr includes a rectification switch SWr and an output capacitor Co, and the rectification switch SWr may be optionally replaced with a passive diode. In general, the controller 4B controls the switch SW and the secondary-side rectification circuit Cr to store and release energy in the transformer 2B, so as to convert a DC power source V_DC received by the isolated converter 400 through the stored/released energy of the transformer 2B into an auxiliary power source V_AUX. The primary-side coil 22B and the secondary-side coil 24B of the transformer 2B can form a planar transformer to facilitate placement on a circuit board, and this will be further explained later and will not be described in detail here. In one embodiment, the circuit structure of the primary-side circuit 1B and the secondary-side circuit 3B is only a schematic example. Any primary-side circuit 1B and the secondary-side circuit 3B that can form a structure of the isolated converter 400 are all should be included in the scope of this embodiment.

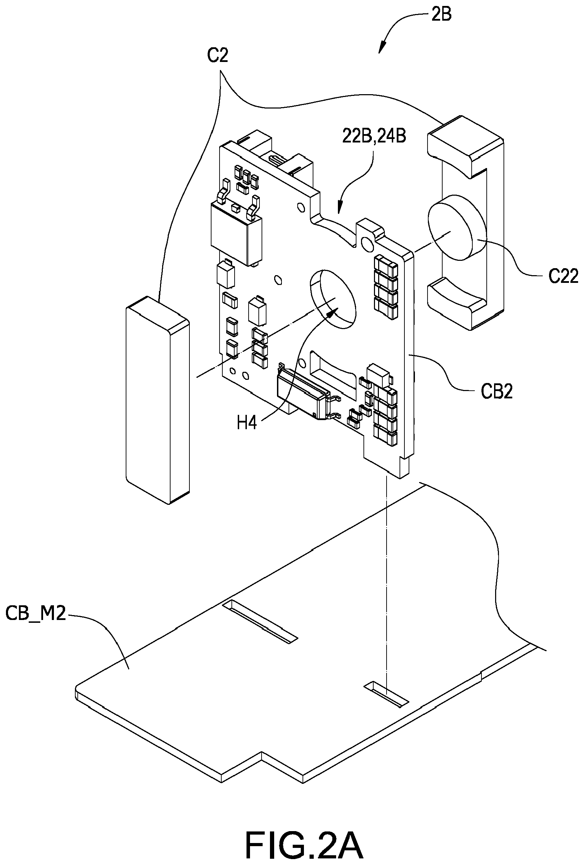

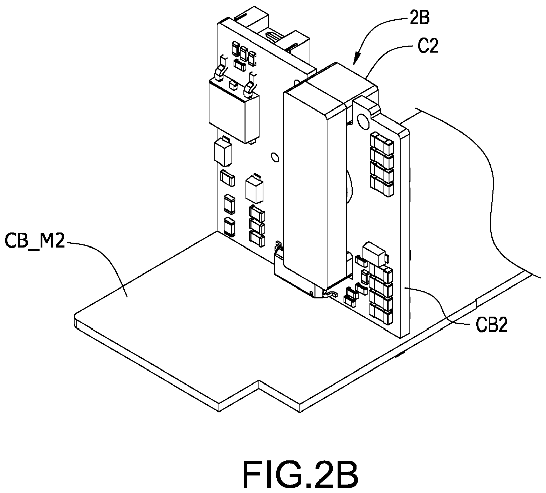

Please refer to FIG. 2A, which shows an exploded view of the three-dimensional circuit structure of a circuit board of the present disclosure; please refer to FIG. 2B, which shows an assembly view of the three-dimensional circuit structure of the circuit board of the present disclosure, and also refer to FIG. 1. The transformer 2B is configured on a circuit board CB2, and the primary-side circuit 1B, the secondary-side circuit 3B, and the controller 4B may be configured on a main circuit board CB_M2. Both the primary-side coil 22B and the secondary-side coil 24B of the transformer 2B have a planar trace structure, and formed on the circuit board CB2, so that the iron core C2 is directly placed on the primary-side coil 22B and the secondary-side coil 24B of the circuit board CB2 to form the transformer 2B. In particular, the iron core C2 includes a core pillar C22, and the core pillar C22 is directly sleeved on the circuit board CB2 through the iron core C2 and penetrates a through hole H4 of the circuit board CB2. Since the transformer 2B does not have a traditional winding frame for winding coils, and all traces are formed on the circuit board CB2, the transformer 2B has a planar structure and forms a planar transformer. Since the planar transformer is relatively flat, the height of the circuit board CB2 is small. Therefore, the circuit board CB2 can be plugged into the main circuit board CB_M2 by plugging to form the circuit structure of FIG. 1, so as to save the use space of the main circuit board CB_M2, but it does not exclude the possibility that the circuit board CB2 may be formed or configured in one of the blocks of the main circuit board CB_M2.

Therefore, the isolated converter 400 mainly forms the primary-side coil 22B and the secondary-side coil 24B of the transformer 2B on the circuit board CB2, so that the planar transformer can be planarized to significantly increase the space utilization of the isolated converter 400 to achieve high power density requirements. In addition, the isolated converter 400 also has a small size due to the use of a planar transformer, which can significantly increase the operating frequency of the isolated converter 400. Therefore, the rectification switch SWr of the switch SW and the secondary-side rectification circuit Cr can use third-generation semiconductor components such as wide bandgap (WBG) as the main power switch, so that the isolated converter 400 has the advantages of higher efficiency, significantly reduced power switch size, lighter weight, and increased heat dissipation performance.

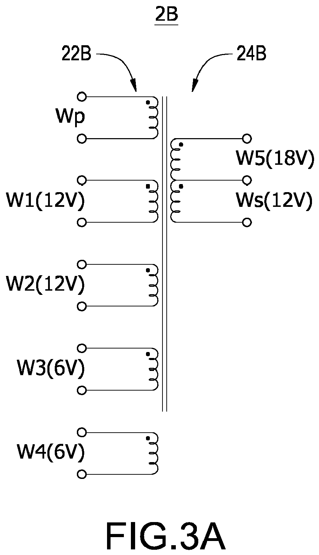

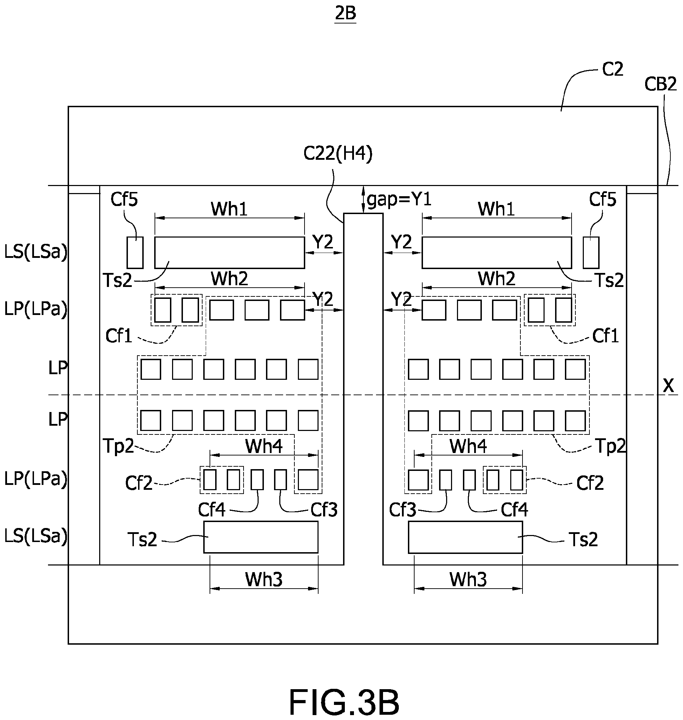

Please refer to FIG. 3A, which shows a circuit diagram of a transformer coil of the present disclosure; please refer to FIG. 3B, which shows a schematic diagram of the transformer trace configuration of the present disclosure, and also refer to FIG. 1 to FIG. 2B. In FIG. 3A, the transformer 2B includes a primary side and a secondary side. The primary side includes a primary-side coil 22B and the secondary side includes a secondary-side coil 24B. The transformer 2B may also optionally include auxiliary coils W1, W2, W3, W4, W5, and the auxiliary coil W5 may form a center-tapped coil structure with the secondary-side coil 24B. In particular, the auxiliary coils W1, W2, W3, W4, W5 may couple the energy provided by the primary-side coil 22B through coupling manner, and the voltage acquired by coupling can be adjusted by adjusting the number of turns thereof. Furthermore, the auxiliary coils W1, W2, W3, W4, W5 may be used for detection of the auxiliary power source of supplying power to the load 300 according to different output voltage requirements. In one embodiment, the number of auxiliary coils W1, W2, W3, W4, W5 and their structural characteristics (independent or center-tapped, etc.) are only schematic examples and are not limited to FIG. 3A.

FIG. 3B shows a schematic cross-sectional view of the circuit board CB2 to focus on the main features of the present disclosure, only the block of the transformer 2B is shown in the cross-sectional position. In FIG. 3B, the circuit board CB2 is a multi-layer board (a 6-layer board is used as an example here, but is not limited to this). The circuit board CB2 includes a plurality of primary-side layers LP and a plurality of secondary-side layers LS, and the two sides away from the center line X are the top layer and the bottom layer of the circuit board CB2 respectively. A plurality of primary-side traces Tp2 are respectively formed on the primary-side layer LP of the circuit board CB2, and each primary-side layer LP includes at least one primary-side trace Tp2 that surrounds several turns (as shown in FIG. 3B with four primary-side layers LP, but not limited to this). The primary-side traces Tp2 may be connected in series through the interconnection of each primary-side layer LP (for example, using via holes, not shown) to serve as the primary-side coil 22B coupled to the primary-side circuit 1B.

A plurality of secondary-side traces Ts2 are respectively formed on the secondary-side layer LS of the circuit board CB2, and each layer of the secondary-side layer LS includes at least one secondary-side trace Ts2 that surrounds several turns (as shown in FIG. 3B with two secondary-side layers Ls, but not limited to this). The secondary-side traces Ts2 may be connected in series through the interconnection of each secondary-side layer LS (for example, using via holes, not shown) to serve as the second second-side coil 24B coupled to the secondary-side circuit 3B. In one embodiment, the material of the traces formed by each layer board may be copper foil, but it does not exclude the use of other metal foils that are easy to conduct electricity (such as but not limited to gold, silver, etc.).

The iron core C2 surrounds the circuit board CB2, and the iron core C2 includes a core pillar C22. The core pillar C22 penetrates the through hole H4 of the circuit board CB2, so that the primary-side trace Tp2 and the secondary-side trace Ts2 surround the through hole H4. After the iron core C2 is sleeved on the primary-side trace Tp2 and the secondary-side trace Ts2, a closed magnetic circuit can be formed to form the transformer 2B. Furthermore, as shown in FIG. 3B, the transformer 2B is formed as follows: the primary-side trace Tp2 is close to the center of the circuit board (i.e., the center line X), and the secondary-side trace Ts2 is away from the center relative to the primary-side trace Tp2 to form a sandwich trace.

That is, the primary-side trace Tp2 is formed at a relatively central position in the circuit board CB2, and the secondary-side trace Ts2 is formed at a position close to the top or bottom layer of the circuit board CB2, so that the leakage inductance of the transformer 2B can be reduced and the efficiency of the isolated converter 400 can be increased. In particular, the trace design of the transformer 2B is not limited to the sandwich trace. Specifically, if the sandwich trace design is not adopted (for example, but not limited to, the primary-side layer LP is configured close to the top layer, and the secondary-side layer LS is configured close to the bottom layer), the coupling capacitance between the primary-side layer LP and the secondary-side layer LS can be reduced, thereby reducing noise during operation of the transformer 2B.

On the other hand, the secondary-side layer LS and the primary-side layer LP respectively include a secondary-side adjacent layer LSa and a primary-side adjacent layer LPa adjacent to each other. A plurality of auxiliary traces Cf1, Cf2, Cf3, Cf4 are respectively formed on the primary-side adjacent layer LPa of the circuit board CB2, and the primary-side adjacent layer LPa may include at least one auxiliary trace Cf1, Cf2, Cf3, Cf4. The auxiliary traces Cf1, Cf2, Cf3, Cf4 can be configured in the single-layer primary-side adjacent layer LPa to form the auxiliary coils W1, W2, W3, W4, and may also be connected through each primary-side adjacent layer LPa (for example, using via holes (not shown), so that the auxiliary wirings Cf1, Cf2, Cf3, Cf4 of the same path are connected in series to serve as the auxiliary coils W1, W2, W3, W4.

Similarly, the auxiliary trace Cf5 may be formed on the secondary-side adjacent layer LSa of the circuit board CB2, and the secondary-side adjacent layer LSa may include at least one auxiliary trace Cf5. The auxiliary trace Cf5 may be arranged on the single-layer secondary-side adjacent layer LSa to form the auxiliary coil W5, or the auxiliary trace Cf5 on the same path may be connected in series through the interconnection of each secondary-side adjacent layer LSa (for example, using via holes, not shown) to serve as the auxiliary coil W5. In addition, when the number of layers of the secondary-side layer LS and the primary-side layer LP is one (that is, the circuit board CB2 is a double-layer board and includes the top layer and the bottom layer), the secondary-side layer LS is the secondary-side adjacent layer LSa, and the primary-side layer LP is the primary-side adjacent layer LPa. The secondary-side adjacent layer LSa includes a secondary-side trace Ts2 that surrounds the through hole H4 for several turns and an auxiliary trace Cf5. The primary-side adjacent layer LPa includes a primary-side trace Tp2 that surrounds the through hole H4 for several turns and at least one auxiliary trace Cf1, Cf2, Cf3, Cf4. Therefore, when the circuit board CB2 is a double-layer board, its structure and achievable functions can be inferred from the descriptions in FIG. 1 to FIG. 3B of the present disclosure and the corresponding paragraphs, and will not be described again here.

In particular, the auxiliary traces Cf1, Cf2, Cf3, Cf4, Cf5 may selectively adjust the number of turns surrounding the through hole H4 according to the voltage required by the back-end circuit. Therefore, the auxiliary traces Cf1, Cf2, Cf3, Cf4 and the primary-side trace Tp2 may have a concentric structure (the center is the through hole H4), and the auxiliary trace Cf5 and the secondary-side trace Ts2 may have a concentric structure (the center is the through hole H4). In particular, the via holes described above can usually be filled with conductive materials (such as but not limited to solder paste and other conductive materials), so that the traces of the transformer 2B can be electrically connected through the via holes.

In FIG. 3B, the secondary-side trace Ts2 in the secondary-side adjacent layer LSa has a first width Wh1, Wh3, and the primary-side trace Tp2 in the primary-side adjacent layer LPa has a second width Wh2, Wh4. Specifically, in the secondary-side adjacent layer LSa, the distance from the secondary-side trace Ts2 farthest from the through hole H4 to the secondary-side trace Ts2 closest to the through hole H4 is the first width Wh1, Wh3. In the primary-side adjacent layer LPa, the distance from the primary-side trace Tp2 farthest from the through hole H4 to the primary-side trace Tp2 closest to the through hole H4 is the second width Wh2, Wh4. In particular, the "width" may be the maximum distance formed by the traces of this layer in any cross-section of the circuit board CB2 perpendicular to the center line (that is, the distance from the trace farthest from the through hole H4 to the trace closest to the through hole H4). In one embodiment, the first width Wh1, Wh3 are larger than the second width Wh2, Wh4, which can make the coupling between the primary-side winding Wp and the secondary-side winding Ws better and make the voltage induced by the secondary-side winding Ws be more stable. That is, in the secondary-side adjacent layer LSa close to the top layer, the first width Wh1 formed by the secondary-side trace Ts2 of the secondary-side adjacent layer LSa can preferably cover the second width Wh2 formed by the primary-side trace Tp2 of the primary-side adjacent layer LPa. Therefore, the area formed by the secondary-side trace Ts2 of the secondary adjacent layer LSa may be larger than the area formed by the primary-side trace Tp2 of the primary-side adjacent layer LPa.

In addition, when the primary-side adjacent layer LPa includes the primary-side trace Tp2 and the auxiliary traces Cf1, Cf2, Cf3, Cf4, the second width Wh2, Wh4 is formed by the auxiliary traces Cf1, Cf2, Cf3, Cf4 and the primary-side trace Tp2. That is, the first width Wh1 formed by the secondary-side trace Ts2 of the secondary-side adjacent layer LSa is preferably greater than or equal to the second width Wh2 formed by the primary-side trace Tp2 and the auxiliary traces Cf1, Cf2, Cf3, Cf4 of the primary-side adjacent layer LPa. In particular, in the primary-side adjacent layer LPa, from the trace farthest from the through hole H4 (which may be the primary-side trace Tp2 or one of the auxiliary traces Cf1, Cf2, Cf3, Cf4) to the trace closest to the through hole H4 (which may be the primary-side trace Tp2 or another of the auxiliary traces Cf1, Cf2, Cf3, Cf4) is the second width Wh2, Wh4. Therefore, the coupling properties of the primary-side winding Wp, the secondary-side winding Ws, and the auxiliary coils W1, W2, W3, W4, W5 can be better, and the voltage induced by each coil can be more stable.

In one embodiment, the corresponding relationship between the first width Wh3 and the second width Wh4 is the same as the first width Wh1 and the second width Wh2, and will not be described again here. In addition, the auxiliary traces Cf1, Cf2, Cf3, Cf4, Cf5 may preferably be configured on the secondary-side adjacent layer LSa and the primary-side adjacent layer LPa to provide a better coupling effect, but are not limited thereto. In other words, the auxiliary traces Cf1, Cf2, Cf3, Cf4, Cf5 can be configured in any one of the secondary-side layer LS and the primary-side layer LP, as long as a suitable voltage can be acquired through coupling.

In FIG. 3B, the iron core C2 may also include an air gap gap to increase the magnetic resistance through the air gap configuration to avoid magnetic saturation of the transformer 2B during operation. The air gap gap can usually be formed on the core pillar C22, but the shaped and position of the air gap gap can be determined according to the actual requirements, and they are not limited to FIG. 3B. In particular, the air gap gap has a first distance Y1, and the primary-side trace Tp2, the secondary-side trace Ts2 and the through hole H4 have a plurality of second distances Y2, and the second distances Y2 are respectively greater than or equal to three times the first distance Y1. Specifically, maintaining a specific distance between the trace and the air gap gap can reduce the cutting loss of the transformer 2B and increase the efficiency. Therefore, it is a better implementation to set the distance between the secondary-side trace Ts2 and the through hole H4 to three times the air gap gap.

On the other hand, since the transformer 2B forms traces on the circuit board CB2, the distance between the primary-side trace Tp2, the secondary-side trace Ts2 and the through hole H4 on each layer of the circuit board CB2 can be adjusted through simple circuit design software. Therefore, compared with the traditional transformer that can only grind the air gap on the iron core C2 and cannot adjust the coil distance, the transformer 2B of the present disclosure uses a trace structure formed on the circuit board CB2, which can achieve the effect of fine-tuning the second distance Y2. In addition, the auxiliary traces Cf1, Cf2, Cf3, Cf4, Cf5 may preferably have a third distance from the through hole H4, and it is a preferred implementation that the third distance is greater than or equal to three times the first distance Y1.

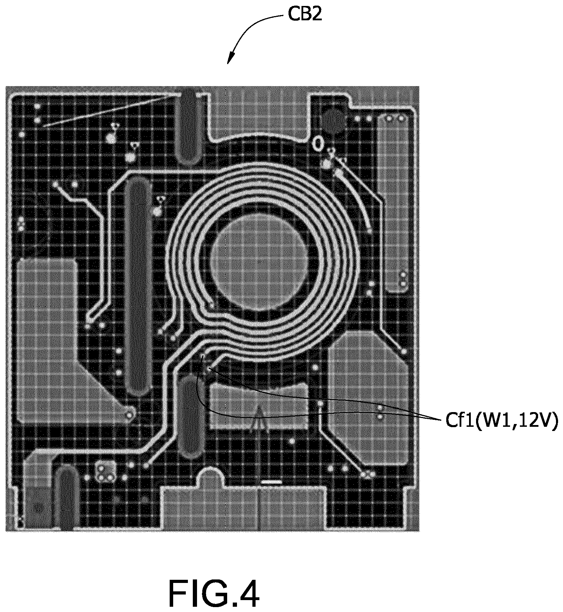

Please refer to FIG. 4, which shows a schematic diagram of the trace configuration of the primary-side adjacent layer of the present disclosure, and also refer to FIG. 1 to FIG. 3B. In FIG. 4, the trace configuration of the primary-side adjacent layer LPa close to the top layer of the circuit board CB2 is illustrated, and the configuration includes the primary-side trace Tp2 and the auxiliary trace Cf1. In FIG. 4, the auxiliary trace Cf1 can be configured in fractional turns (that is, the number of turns of the trace of this layer around the through hole H4 is not an integer number of turns), so that the transformer 2B can fine-tune the voltage acquired to achieve the requirements of better application. Specifically, in order to make the voltage value of the output voltage more stable and finely adjusted, the transformer 2B can fine-tune the voltage induced by the auxiliary trace Cf1 by configuring an additional half turn (that is, auxiliary trace Cf1 is configured with an additional half turn), 1/4 turn, or even 1/10 turn (take FIG. 4 as an example, the auxiliary trace Cf1 is 2.5 turns), so that the voltage can be more accurate (such as but not limited to 12V, etc.). In particular, although only the number of turns of the auxiliary trace Cf1 surrounding the through hole H4 is shown in FIG. 4, which is not an integer number of turns, the similar primary-side trace Tp2, the secondary-side trace Ts2, and the auxiliary traces Cf2, Cf3, Cf4, Cf5 can also fine-tune the induced voltage through fractional turns, and no further details will be given here.

## Claims

1. A planar transformer (2B) applied to an isolated converter (400), the isolated converter (400) comprising a primary-side circuit (1B) and a secondary-side circuit (3B), **characterized in that** the planar transformer (2B) comprising:
a circuit board (CB2) arranged in the isolated converter (400), the circuit board (CB2) comprising:
a primary-side trace (Tp2) formed on a primary-side layer (LP) of the circuit board (CB2), and the primary-side trace (Tp2) configured to serve as a primary-side coil (22B) coupled to the primary-side circuit (1B), and
a secondary-side trace (Ts2) formed on a secondary-side layer (LS) of the circuit board (CB2), and the secondary-side trace (Ts2) configured to serve as a secondary-side coil (24B) coupled to the secondary-side circuit (3B), and
an iron core (C2) comprising a core pillar (C22), the core pillar (C22) penetrating a through hole (H4) of the circuit board (CB2), and the primary-side trace (Tp2) and the secondary-side trace (Ts2) surrounding the through hole (H4),
wherein the secondary-side trace (Ts2) has a first width (Wh1, Wh3) and the primary-side trace (Tp2) has a second width (Wh2, Wh4), and the first width (Wh1, Wh3) is greater than the second width (Wh2, Wh4).

2. The planar transformer (2B) as claimed in claim 1, wherein the number of the primary-side layers (LP) is plural and the number of the secondary-side layers (LS) is plural; each primary-side layer (LP) comprises the primary-side trace (Tp2), and each secondary-side layer (LS) comprises the secondary-side trace (Ts2); the primary-side traces (Tp2) are close to a center of the circuit board (CB2) and the secondary-side traces (Ts2) are away from the center to form a sandwich trace.

3. The planar transformer (2B) as claimed in claim 1, wherein the circuit board (CB2) further comprises:
at least one auxiliary trace (Cfl, Cf2, Cf3, Cf4, Cf5) formed on the primary-side layer (LP) to serve as at least one auxiliary coil (W1, W2, W3, W4, W5),
wherein the at least one auxiliary trace (Cfl, Cf2, Cf3, Cf4, Cf5) surrounds the through hole (H4) to form a concentric structure with the primary-side trace (Tp2).

4. The planar transformer (2B) as claimed in claim 3, wherein the second width (Wh2, Wh4) is formed by the at least one auxiliary trace (Cfl, Cf2, Cf3, Cf4, Cf5) and the primary-side trace (Tp2), and the first width (Wh1, Wh3) is greater than or equal to the second width (Wh2, Wh4).

5. The planar transformer (2B) as claimed in claim 3, wherein the number of turns of surrounding the hole of at least one of the primary-side trace (Tp2), the secondary-side trace (Ts2), and the at least one auxiliary trace (Cfl, Cf2, Cf3, Cf4, Cf5) is not an integer.

6. The planar transformer (2B) as claimed in claim 1, wherein the primary-side circuit (1B) and the secondary-side circuit (3B) are arranged on a main circuit board (CB_M2), and the circuit board (CB2) is plugged into the main circuit board (CB_M2).

7. A planar transformer (2B) applied to an isolated converter (400), the isolated converter (400) comprising a primary-side circuit (1B) and a secondary-side circuit (3B), **characterized in that** the planar transformer (2B) comprising:
a circuit board (CB2) arranged in the isolated converter (400), the circuit board (CB2) comprising:
a primary-side trace (Tp2) formed on a primary-side layer (LP) of the circuit board (CB2), and the primary-side trace (Tp2) configured to serve as a primary-side coil (22B) coupled to the primary-side circuit (1B), and
a secondary-side trace (Ts2) formed on a secondary-side layer (LS) of the circuit board (CB2), and the secondary-side trace (Ts2) configured to serve as a secondary-side coil (24B) coupled to the secondary-side circuit (3B), and
an iron core (C2) comprising a core pillar (C22), the core pillar (C22) penetrating a through hole (H4) of the circuit board (CB2), and the primary-side trace (Tp2) and the secondary-side trace (Ts2) surrounding the through hole (H4),
wherein the iron core (C2) comprises an air gap (gap) having a first distance (Y1); the primary-side trace (Tp2), the secondary-side trace (Ts2), and the through hole (H4) have a plurality of second distances (Y2), and the second distances (Y2) are respectively greater than or equal to three times of the first distance (Y1).

8. The planar transformer (2B) as claimed in claim 7, wherein the secondary-side trace (Ts2) has a first width (Wh1, Wh3) and the primary-side trace (Tp2) has a second width (Wh2, Wh4), and the first width (Wh1, Wh3) is greater than the second width (Wh2, Wh4).

9. The planar transformer (2B) as claimed in claim 7, wherein the number of the primary-side layers (LP) is plural and the number of the secondary-side layers (LS) is plural; each primary-side layer (LP) comprises the primary-side trace (Tp2), and each secondary-side layer (LS) comprises the secondary-side trace (Ts2); the primary-side traces (Tp2) are close to a center of the circuit board (CB2) and the secondary-side traces (Ts2) are away from the center to form a sandwich trace.

10. The planar transformer (2B) as claimed in claim 7, wherein the circuit board (CB2) further comprises:
at least one auxiliary trace (Cfl, Cf2, Cf3, Cf4, Cf5) formed on the primary-side layer (LP) to serve as at least one auxiliary coil (W1, W2, W3, W4, W5),
wherein the at least one auxiliary trace (Cfl, Cf2, Cf3, Cf4, Cf5) surrounds the through hole (H4) to form a concentric structure with the primary-side trace (Tp2).

11. The planar transformer (2B) as claimed in claim 10, wherein the at least one auxiliary trace (Cfl, Cf2, Cf3, Cf4, Cf5) and the through hole (H4) have at least one third distance (Y3), and the at least one third distance (Y3) is greater than or equal to three times of the first distance (Y1).

12. The planar transformer (2B) as claimed in claim 10, wherein the number of turns of surrounding the hole of at least one of the primary-side trace (Tp2), the secondary-side trace (Ts2), and the at least one auxiliary trace (Cfl, Cf2, Cf3, Cf4, Cf5) is not an integer.

13. The planar transformer (2B) as claimed in claim 10, wherein the second width (Wh2, Wh4) is formed by at least one auxiliary trace (Cfl, Cf2, Cf3, Cf4, Cf5) and the primary-side trace (Tp2), and the first width (Wh1, Wh3) is greater than or equal to the second width (Wh2, Wh4).

14. The planar transformer (2B) as claimed in claim 7, wherein the primary-side circuit (1B) and the secondary-side circuit (3B) are arranged on a main circuit board (CB_M2), and the circuit board (CB2) is plugged into the main circuit board (CB_M2).
